# EUROPÄISCHE PATENTSCHRIFT

(11) **EP 3 211 847 B1**
(45) Veröffentlichungstag und Bekanntmachung des Hinweises auf die Patenterteilung: **23.09.2020**
(21) Anmeldenummer: 16178244.6
(22) Anmeldetag: 06.07.2016
(51) Int. Cl.: H04L 27/26, H04L 7/00, H03D 3/00

(54) **VERFAHREN ZUR FREQUENZKORREKTUR EINES OSZILLATORS EINES SENSORKNOTENS EINES DRAHTLOSEN SENSORNETZWERKES**
METHOD FOR FREQUENCY CORRECTION OF AN OSCILLATOR OF A SENSOR NODE OF A WIRELESS SENSOR NETWORK
PROCÉDÉ DE CORRECTION DE FRÉQUENCE DE L'OSCILLATION D'UN NOEUD DE CAPTEURS D'UN RÉSEAU DE CAPTEURS SANS FIL

(30) Priorität: 29.02.2016 DE 102016203249
(43) Veröffentlichungstag der Anmeldung: 30.08.2017
(73) Patentinhaber: Fraunhofer-Gesellschaft zur Förderung der angewandten Forschung e.V., 80686 München (DE); Friedrich-Alexander-Universität Erlangen-Nürnberg, 91054 Erlangen (DE)
(72) Erfinder: Tröger, Hans-Martin, 91054 Erlangen (DE); Franke, Norbert, 91058 Erlangen (DE); Heuberger, Albert, 91056 Erlangen (DE); Robert, Jörg, 91080 Uttenreuth (DE)
(74) Vertreter: Pfenning, Meinig & Partner mbB

(56) Entgegenhaltungen:
- TROEGER HANS-MARTIN ET AL: "Frequency and Time Synchronization of a Wireless Sensor Network with Signals of Opportunity", PTTI 2014 - PROCEEDINGS OF THE 46TH ANNUAL PRECISE TIME AND TIME INTERVAL SYSTEMS AND APPLICATIONS MEETING, THE INSTITUTE OF NAVIGATION, 8551 RIXLEW LANE SUITE 360 MANASSAS, VA 20109, USA, 4. Dezember 2014 (2014-12-04), Seiten 117-123, XP056008775,
- JEREMY ELSON ET AL: "Fine-grained network time synchronization using reference broadcasts", OPERATING SYSTEMS REVIEW, ACM, NEW YORK, NY, US, Bd. 36, Nr. SI, 31. Dezember 2002 (2002-12-31), Seiten 147-163, XP058141972, ISSN: 0163-5980, DOI: 10.1145/844128.844143

## Beschreibung

Die Erfindung betrifft ein Verfahren zur Frequenzkorrektur (Syntonisation) der lokalen Referenzoszillatoren von Sensorknoten eines Sensorknotennetzwerks.

Drahtlose Sensornetzwerke gewinnen im alltäglichen Leben stetig an Bedeutung. Zählerstände von Gas- und Wasserzählern werden heutzutage oft drahtlos vom Netzbetreiber abgerufen. Ebenso sind häufig Anlagen in der Produktion oder der Logistik mit drahtlosen Sensoren ausgestattet. Ein Sensor mit einer Kommunikationseinheit zur Übermittelung der Sensordaten und gegebenenfalls weiterer Daten wird hier als Sensorknoten bezeichnet. Eine Vielzahl von Sensorknoten innerhalb eines bestimmten Bereiches kann ein Sensornetzwerk bilden.

Für viele Anwendungen ist die Kenntnis der genauen Position der Sensorknoten von besonderer Bedeutung. Oft werden die Positionen der Sensorknoten mit Hilfe eines Netzwerks aus stationären Empfängern bestimmt, wobei ein solcher Empfänger auch Bestandteil eines Sensorknotens eines Sensornetzwerkes sein kann. Mit verschiedenen Ortungsverfahren wie einer direkten Laufzeitmessung von Signalen zwischen mehreren Empfängern oder einer differentiellen Laufzeitmessung von Signalen zwischen mehreren Empfängern lässt sich die exakte Position des zu lokalisierenden Sensorknotens bestimmen.

Bei solchen Verfahren ist die Bereitstellung von hochgenauen Zeitinformationen in jedem Sensorknoten des Sensornetzwerkes von besonderer Bedeutung. Üblicherweise enthält jeder Sensorknoten einen lokalen Referenzoszillator als Taktgenerator, von dessen Frequenz die für den Betrieb des Sensorknotens benötigten Zeitinformationen abgeleitet werden.

Ein Aspekt der Bereitstellung von hochgenauen Zeitinformationen in jedem Sensorknoten des Sensornetzwerkes ist die Syntonisation der lokalen Taktgeneratoren der Sensorknoten. Die Syntonisation stellt sicher, dass die lokalen Taktgeneratoren in jedem Sensorknoten mit der gleichen Taktrate laufen. Die Syntonisation wird auch als Frequenzsynchronisation bezeichnet.

Für viele der beispielhaft aufgeführten Ortungsverfahren ist bereits eine phasenstarre Beziehung der Referenzoszillatoren der Sensorknoten ausreichend.

Ein weiterer Aspekt der Bereitstellung von hochgenauen Zeitinformationen in jedem Sensorknoten des Sensornetzwerkes ist die Zeitsynchronisation der lokalen Taktgeneratoren der Sensorknoten. Die Zeitsynchronisation stellt sicher, dass die lokalen Taktgeneratoren in jedem Sensorknoten zu einem gegebenen Zeitpunkt den gleichen Zeitwert ausgeben.

Bekannt ist die Bereitstellung von hochgenauen Zeitinformation mittels des GPS-Systems. Jedoch ist oft die erreichbare Genauigkeit nicht ausreichend, und die Anwendung ist im Indoor Bereich nicht möglich. Für den Indoor Bereich gibt es aktuell nur die Möglichkeit auf kabelgebundene Taktverteilungen zurückzugreifen, was jedoch viele Anwendungen, insbesondere drahtlose Sensorknoten, ausschließt.

Die Veröffentlichung "Time and Frequency Synchronization of a Wireless Sensor Network with Signals of Opportunity" (PTTI 2014 - Proceedings of the 2014 Precise Time and Time Interval Meeting) diskutiert die die Bestimmung und Korrektur des Frequenzfehlers des lokalen Taktgebers eines Sensorknotens unter Verwendung der Signale eines DVB-T Senders.

Der vorliegenden Erfindung liegt die Aufgabe zugrunde, ein Verfahren für die Frequenzkorrektur des lokalen Referenzoszillators eines Sensorknotens anzugeben.

Die Aufgabe wird mit dem Verfahren gemäß Patentanspruch 1 gelöst. Die weiteren Patentansprüche geben vorteilhafte Ausgestaltungen des erfindungsgemäßen Verfahrens an.

Das erfindungsgemäße Verfahren beruht auf der Verwendung von sogenannten "Signals of Opportunity" als Frequenzreferenz. Als Signal of Opportunity werden Funksignale bezeichnet, die ursprünglich für eine andere Zweckbestimmung abgestrahlt werden und für eine Frequenzsynchronisation eines lokalen Referenzoszillators mit ihrer Sendefrequenz geeignet sind.

Als Signal of Opportunity sind beispielsweise Fernseh- oder Rundfunksignale (DVB-T, DAB) oder auch Signale von Kommunikationsnetzen (GSM, UMTS, LTE) geeignet. Diese Signale werden üblicherweise innerhalb eines geographischen Gebietes von mehreren unterschiedlichen Standorten mit hoher Sendeleistung und Bandbreite abgestrahlt und können auch in Gebäuden ohne Sichtverbindung zum Sender mit einem guten Signal-zu-Rauschverhältnis empfangen werden. Außerdem weisen diese Signale vorteilhafte Merkmale auf, wie die Koppelung an eine hochgenaue Referenzfrequenz, eine hohe Frequenzstabilität und charakteristische Signalsequenzen, aus denen Informationen für den Abgleich von Frequenz und Phase der lokalen Referenzoszillatoren der Sensorknoten gewonnen werden können.

Das erfindungsgemäße Verfahren zur Frequenzkorrektur eines Oszillators eines Sensorknotens eines Sensornetzwerkes umfasst die Verfahrensschritte:
- Empfangen eines Sendesignals eines ersten Senders mit einer Modulation nach dem Orthogonalen Frequenzmultiplexverfahren (OFDM);
- Bestimmen der Frequenzabweichung des Oszillators anhand des empfangenen Sendesignals;
- Bestimmen eines Korrektursignals zur Korrektur der Frequenzabweichung des Oszillators;
- Korrektur der Frequenz des Oszillators mit dem Korrektursignal;
wobei der Sensorknoten mit weiteren Sensorknoten kommunikativ verbunden ist und der Sensorknoten von einem weiteren Sensorknoten die Information über den von dem weiteren Sensorknoten aktuell zur Frequenzkorrektur verwendeten zweiten Sender empfängt und daraufhin die Frequenzkorrektur mit diesem Sender fortführt, wenn anhand einer Unterschreitung von Signal-Störabstand oder Symbol/Rauschverhältnis eine Abschattung des ersten Senders erkannt wird.
In einer Weiterbildung des Verfahrens wird zur Bestimmung der Frequenzabweichung des Oszillators eine Trägerfrequenzabweichung des empfangenen Sendesignals bestimmt.
In einer weiteren Weiterbildung des Verfahrens wird zur Bestimmung der Frequenzabweichung des Oszillators ein Abtastratenfehler des empfangenen Sendesignals bestimmt.
In einer weiteren Weiterbildung des Verfahrens wird der Abtastratenfehler unabhängig von der Korrektur der Frequenzabweichung des Oszillators korrigiert.
In einer weiteren Weiterbildung des Verfahrens erfolgt die Bestimmung der Frequenzabweichung anhand der Phasenbeziehungen empfangener Einzelträger des Sendesignals.
In einer weiteren Weiterbildung des Verfahrens erfolgt die Bestimmung des Abtastratenfehlers anhand der Phasenbeziehungen empfangener Einzelträger des Sendesignals.
In einer weiteren Weiterbildung des Verfahrens wird die Bestimmung der Frequenzabweichung für den Zeitraum der Übertragung eines Sendesymbols vorgenommen.
In einer weiteren Weiterbildung des Verfahrens wird die Bestimmung der Frequenzabweichung für den Zeitraum der Übertragung zweier aufeinander folgender Sendesymbole vorgenommen.
In einer weiteren Weiterbildung des Verfahrens werden
- nach dem Empfangen des Sendesignals aus dem empfangenen Sendesignal die Kanalimpulsantwort des Übertragungskanals bestimmt;
- aus der Kanalimpulsantwort die Signale unterschiedlicher Übertragungspfade des empfangenen Sendesignals bestimmt; und
- die Frequenzabweichung des Oszillators anhand des Signals eines Übertragungspfades bestimmt.
In einer weiteren Weiterbildung des Verfahrens wird die Frequenzabweichung des Oszillators anhand der Signale mehrerer Übertragungspfade bestimmt.
In einer weiteren Weiterbildung des Verfahrens wird ein Signal zur Bestimmung der Frequenzabweichung des Oszillators anhand seiner Signalenergie, seiner Signalqualität oder seiner zeitlichen Beziehung zu anderen Signalen der Kanalimpulsantwort ausgewählt.
In einer weiteren Weiterbildung des Verfahrens werden die Sendesignale mehrerer Sender empfangen.
In einer weiteren Weiterbildung des Verfahrens enthält das empfangene Sendesignal Zeitinformationen und der Oszillator wird anhand der Zeitinformation zeitsynchronisiert.

Die Erfindung wird nachstehend anhand von Ausführungsbeispielen näher erläutert. Die beigefügten Zeichnungen stellen dar:
- Figur 1: ein Blockschaltbild des Eingangsblocks eines Empfängers für den Empfang von OFDM modulierten Signalen für einen Sensorknoten;
- Figur 2: die aus einer Trägerfrequenzverschiebung resultierende Fehlabtastung der Einzelträger eines OFDM Signals;
- Figur 3: die aus einem Abtastratenfehler resultierende Fehlabtastung der Einzelträger eines OFDM Signals;
- Figur 4: den Einfluss von Trägerfrequenzverschiebung und Abtastratenfehler auf die Phasen der Einzelträger eines OFDM Signals;
- Figur 5: einen OFDM Empfänger;
- Figur 6A: ein Ausführungsbeispiel eines OFDM Empfängers mit Regelvorrichtung zur Korrektur der Oszillatorfrequenz;
- Figur 6B: ein weiteres Ausführungsbeispiel eines OFDM Empfängers mit Regelvorrichtung zur Korrektur der Oszillatorfrequenz;
- Figur 7: den Einfluss der Abweichung des Abtastratenfehlers (SCO) auf die Schätzung der Trägerfrequenzverschiebung (CFO);
- Figur 8: die Darstellung einer Kanalimpulsantwort bei Mehrwegempfang;
- Figur 9: die zeitliche Abhängigkeit eines Peaks in der Kanalimpulsant-wort in Abhängigkeit vom Abtastratenfehler (SCO);
- Figur 10: die Darstellung einer Kanalimpulsantwort bei Mehrwegempfang für zwei Sender in einem Single-Frequency-Network (SFN).

Für viele Verfahren der Ortung von Sensorknoten ist eine Synchronisation der lokalen Referenzoszillatoren der einzelnen Sensorknoten erforderlich. Bei der Synchronisation muss zwischen der Frequenzsynchronisation und der Zeitsynchronisation unterschieden werden. Die Frequenzsynchronisation verfolgt das Ziel, die Frequenz der lokalen Referenzoszillatoren der einzelnen Sensorknoten in Gleichlauf zu bringen oder die Abweichung zu einer externen Referenzfrequenz festzustellen. Unter Zeitsynchronisation ist der Abgleich der unterschiedlichen lokalen Uhrzeiten der einzelnen Sensorknoten auf eine externe Referenzzeit zu verstehen.

Die Frequenzsynchronisation der lokalen Referenzoszillatoren mehrerer Sensorknoten mittels Signals of Opportunity basiert auf der Erkenntnis, dass als Signal of Opportunity genutzte Rundfunksignale und Mobilfunksignale üblicherweise in Bezug auf eine sehr exakte Referenzfrequenz (OCXO, Rubidium - Frequenznormal oder ähnliches) erzeugt werden und damit eine hochgenaue Frequenzreferenz bilden. Ziel der Frequenzsynchronisation ist es nun, die Abweichung zwischen der lokalen unpräzisen Referenzfrequenz der Sensorknoten und der sehr exakten Referenzfrequenz des gewählten SoO zu bestimmen und zu korrigieren, indem aus dem SoO Korrektursignale gewonnen werden, die durch analoge oder digitale Regelung oder auch Mischformen davon die Frequenz des lokalen Referenzoszillators des Sensorknotens korrigieren.

Für die Frequenzsynchronisation ihrer lokalen Referenzoszillatoren verfügen die Sensorknoten über einen Empfangskanal, der das gewählte Signal of Opportunity ganz oder teilweise empfangen kann. Der Oszillator dieses Empfangskanals bildet gleichzeitig den lokalen Referenzoszillator des Sensorknotens. Zudem ist eine weitere drahtlose Datenverbindung (z.B. W-LAN) zwischen den einzelnen Sensorknoten vorteilhaft, um Daten zwischen den Sensorknoten austauschen zu können.
Dazu kann der Sensorknoten eine Sendeeinheit und eine Empfangseinheit für die Datenverbindung sowie eine weitere Empfangseinheiten für das zu empfangende Signal of Opportunity aufweisen, die einen gemeinsamen lokalen Referenzoszillator verwenden.
Alternativ kann der Sensorknoten auch nur eine Empfangseinheit aufweisen, die abwechselnd zwischen dem Datenempfang und dem Empfang des Signal of Opportunity umgeschaltet wird.
Alternativ kann der Sensorknoten auch nur eine Empfangseinheit aufweisen, die für den gleichzeitigen Datenempfang und dem Empfang des Signal of Opportunity ausgebildet ist.

Nachfolgend wird die Frequenzsynchronisation mittels Signals of Opportunity, die nach dem Orthogonalen Frequenzmultiplexverfahren (OFDM) moduliert sind, beschrieben.

Ein OFDM moduliertes Signal besteht aus einer Vielzahl von schmalbandigen Einzelträgern mit konstantem Frequenzabstand. Die zu übertragenden digitalen Daten werden auf die Einzelträger mit einem Modulationsverfahren wie Quadraturphasenumtastung (QPSK) oder Quadraturamplitudenmodulation mit 16 oder 64 Symbolen (16-QAM oder 64-QAM) moduliert.
Bestimmte Einzelträger werden dabei mit einer bekannten, vorgegebenen Symbolsequenz moduliert. Die entsprechende Symbolsequenz wird auch als Pilotsignal bezeichnet. In der zeitlichen Abfolge des Sendesignals wird das Pilotsignal auf einem Teil der Einzelträger kontinuierlich übertragen. Diese Einzelträger werden auch als Pilotträger bezeichnet. Zusätzlich können weitere Einzelträger zu bestimmten Zeiten anstelle der Nutzdaten ebenfalls das Pilotsignal übertragen. Durch eine Korrelation des empfangenen Signals mit bekannten Symbolsequenzen der Pilotsignale kann die Phasen- und Frequenzlage der ein Pilotsignal übertragenden Einzelträger bestimmt werden.

Empfänger für OFDM modulierte Signale bestimmen die Trägerfrequenz des OFDM Signals beziehungsweise die Trägerfrequenzen der Einzelträger sowie die Abtastrate zur Abtastung des Signals mit Bezug auf eine lokale Referenzfrequenz, die von einem Oszillator generiert wird.

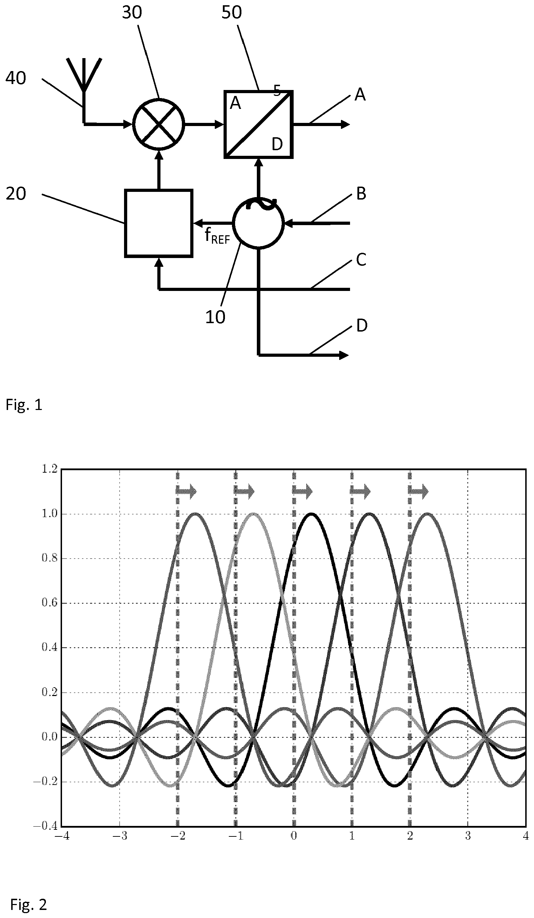

Figur 1 zeigt ein Blockschaltbild des Eingangsblocks eines Empfängers für den Empfang von OFDM modulierten Signalen für einen Sensorknoten.
Der beispielhaft gezeigte Empfänger ist als Direktmischempfänger ausgeführt. Ein Oszillator 10 erzeugt die lokale Referenzfrequenz f_{REF}. Die lokale Referenzfrequenz f_{REF} wird einer Phasenregelschleife (PLL) 20 zugeführt. Die PLL 20 erzeugt, mit der lokalen Referenzfrequenz f_{REF} als Referenz, eine der Trägerfrequenz des Empfangssignals entsprechende Frequenz, die dem Mischer 30 zugeführt wird. Das von einer Antenne 40 empfangene Eingangssignal wird ebenfalls dem Mischer 30 zugeführt. Das Ausgangssignal des Mischers entspricht dem Sendesignal vor der Umsetzung auf die Trägerfrequenz. Nachfolgend wird das Ausgangssignal des Mischers einem Analog/Digital-Wandler 50 zugeführt. Die Abtastfrequenz des Analog/Digital-Wandlers wird ebenfalls aus der lokalen Referenzfrequenz f_{REF} gewonnen. Das Ausgangssignal des Analog/Digital-Wandlers 50 liegt am Ausgang A an. Über den Eingang B kann dem Oszillator 10 ein erstes Korrektursignal zur Korrektur der lokalen Referenzfrequenz f_{REF} zugeführt werden. Über den Eingang C kann der PLL 20 ein zweites Korrektursignal zur Korrektur der von der PLL 20 erzeugten Trägerfrequenz zugeführt werden. Am Ausgang D steht die (gegebenenfalls korrigierte) lokale Referenzfrequenz f_{REF} für die Verwendung in weiteren Baugruppen des Sensorknotens zur Verfügung.

Frequenzabweichungen der lokalen Referenzfrequenz des Empfängers im Vergleich zur Referenzfrequenz des Senders führen zu einer Trägerfrequenzabweichung, die nachfolgend als Trägerfrequenzverschiebung (Carrier Frequency Offset, CFO) bezeichnet wird und/oder zu einem Abtastratenfehler (Sampling Clock Offset, SCO) des empfangenen Signals.

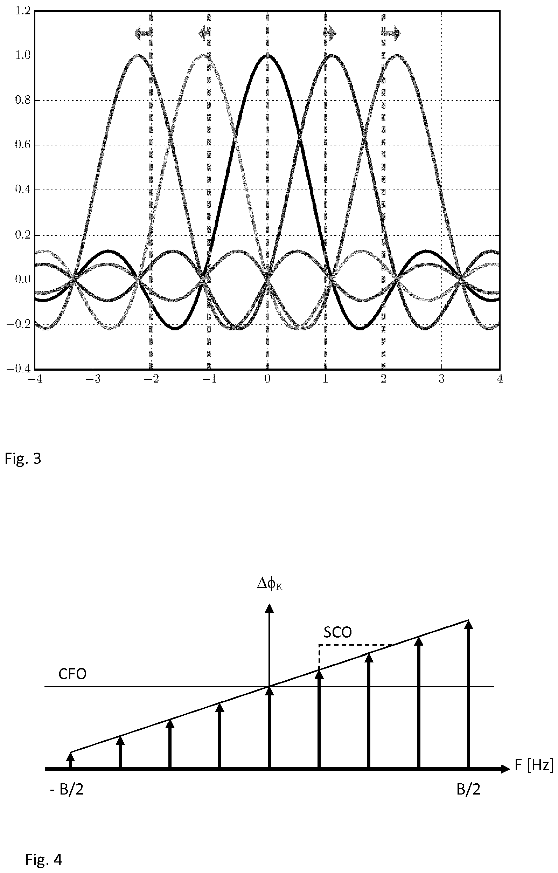

Eine Trägerfrequenzverschiebung äußert sich bereits am Ausgang des Mischers im Frequenzbereich in einem konstanten Frequenzversatz aller Einzelträger im Vergleich zu ihrer jeweiligen Nominalfrequenz. Die Trägerfrequenzverschiebung führt dazu, dass bei der nachfolgenden Analog/DigitalWandlung alle Einzelträger gleichermaßen außerhalb ihres Maximums abgetastet werden und damit die Orthogonalität der Einzelträger verloren geht. Dies ist symbolisch in Figur 2 dargestellt. Figur 2 zeigt beispielhaft fünf Einzelträger eines OFDM Signals. Die x-Achse von Figur 2 zeigt die Frequenz des OFDM Signals normiert auf die Mittenfrequenz des OFDM Signals mit einer Skalierung entsprechend dem nominalen Abstand der Einzelträger. Die γ-Achse von Figur 2 stellt eine normierte Amplitude der Einzelträger dar. Die in Figur 2 dargestellten Kurven stellen die Einzelträger des OFDM Signals dar. Die vertikalen gestrichelten Linien in Figur 2 zeigen die aus der Trägerfrequenzverschiebung resultierende Abtastung außerhalb des Maximums der Einzelträger, während die horizontalen Pfeile die Verschiebung der Abtastung symbolisieren. Die Folge ist eine unerwünschte Inter-Symbol Interferenz zwischen den auf verschiedenen Einzelträgern modulierten Symbolen.
Bei zwei zeitlich aufeinander folgenden Symbolen bewirkt eine Trägerfrequenzverschiebung eine konstante Verschiebung der Phase jedes Einzelträgers.
Ein Abtastratenfehler äußert sich im Frequenzbereich einem linear mit der Frequenz steigenden oder fallenden Versatz des Abtastzeitpunktes der Einzelträger. Dies ist symbolisch in Figur 3 dargestellt. Figur 3 zeigt ebenfalls beispielhaft fünf Einzelträger eines OFDM Signals. Die x-Achse von Figur 3 zeigt die Frequenz des OFDM Signals normiert auf die Mittenfrequenz des OFDM Signals mit einer Skalierung entsprechend dem nominalen Abstand der Einzelträger. Die γ-Achse von Figur 3 stellt eine normierte Amplitude der Einzelträger dar. Die in Figur 3 dargestellten Kurven stellen die Einzelträger des OFDM Signals dar. Die vertikalen gestrichelten Linien in Figur 3 zeigen die aus dem Abtastratenfehler resultierende Abtastung der Einzelträger, während die horizontalen Pfeile die Verschiebung der Abtastung symbolisieren. Daraus folgt, wie in Figur 4 dargestellt, eine linear steigendende oder fallende Phase benachbarter Einzelträger. Die x-Achse von Figur 4 zeigt die Frequenz des OFDM Signals normiert auf die Mittenfrequenz des OFDM Signals, wobei die vertikalen Pfeile die Einzelträger symbolisieren. Die γ-Achse von Figur 4 zeigt die Phasenlage der Einzelträger. Ohne Abtastratenverschiebung würden die die Einzelträger die gleiche Phasenlage aufweisen, wie es durch die mit CFO bezeichnete horizontale Linie dargestellt wird. Die Trägerfrequenzverschiebung bewirkt eine Verschiebung der Phasenlager aller Einzelträger auf der γ-Achse.

Aus den vorgehend beschriebenen, von der Trägerfrequenzverschiebung und/oder dem Abtastratenfehler verursachten Phasenveränderungen der Einzelträger zueinander oder der Einzelträger zweier aufeinander folgender Symbole kann ein Korrektursignal abgeleitet werden, um die lokale Referenzfrequenz des Empfängers zu korrigieren.

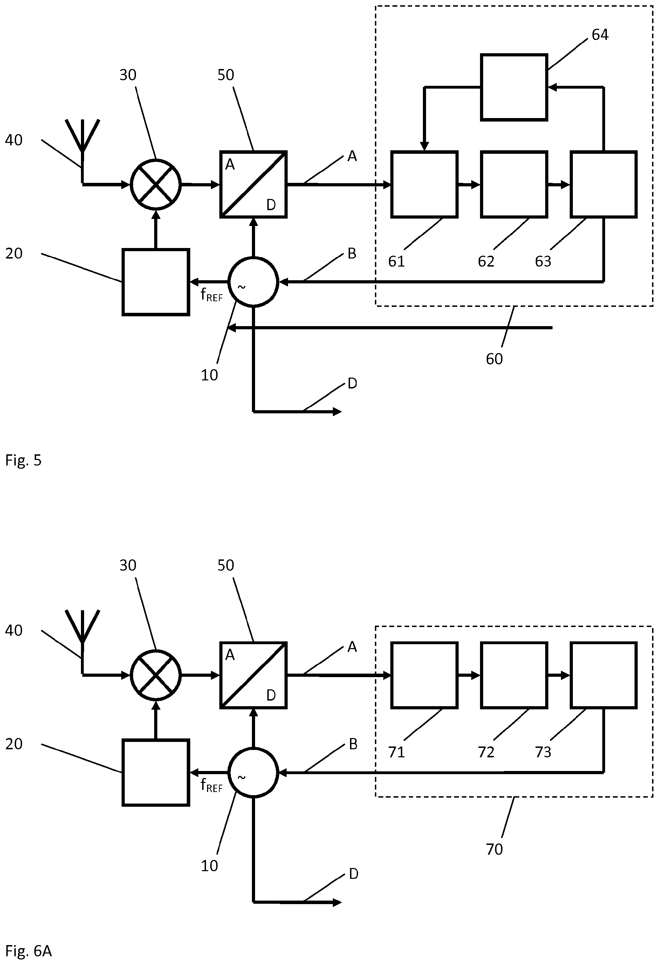

Dies kann beispielsweise mittels einer aus dem Stand der Technik bekannten Regelvorrichtung geschehen, wie sie in Figur 5 dargestellt ist. Die in Figur 5 dargestellte Regelvorrichtung 60 für den in Figur 1 dargestellten Eingangsblock eines Empfängers für den Empfang von OFDM modulierten Signalen verwirklicht einen Algorithmus, bei dem der Abtastratenfehler vor der Bestimmung eines Korrektursignals für die Korrektur der Trägerfrequenzverschiebung in der Regelvorrichtung 60 korrigiert wird. Dazu empfängt die Regelvorrichtung 60 das Ausgangssignal vom Ausgang A des Analog/DigitalWandlers 50 des vorgehend mit Bezug auf Figur 1 beschriebenen Eingangsblocks des Empfängers und führt dieses einem Re-Sampler 61 (Abtastratenkonvertierer) zu, der sehr kleine Abtastratenanpassungen vornehmen kann, um den Abtastratenfehler zu korrigieren. Das Signal des Re-Samplers 61 wird einer FFT 62 zugeführt, deren Ausganssignale einem Schätzer 63 geliefert werden. Der Schätzer 63 schätzt und korrigiert den Abtastratenfehler, indem über ein Schleifenfilter 64 dem Re-Sampler 61 ein Korrektursignal zur Anpassung der Abtastratenanpassung zugeführt wird. Nach der Korrektur des Abtastratenfehlers bestimmt der Schätzer (63) ein Korrektursignal, welches über den Eingang B dem Oszillator zur Korrektur der Oszillatorfrequenz zugeführt wird.

Nachteilig ist dabei die hohe Komplexität der Regelvorrichtung, insbesondere des Re-Samplers, die einen hohen Schaltungsaufwand und hohe Rechenleistung bei der Verarbeitung erfordern und damit für den Einsatz in Sensorknoten mit begrenzter Rechenleistung nicht geeignet sind.

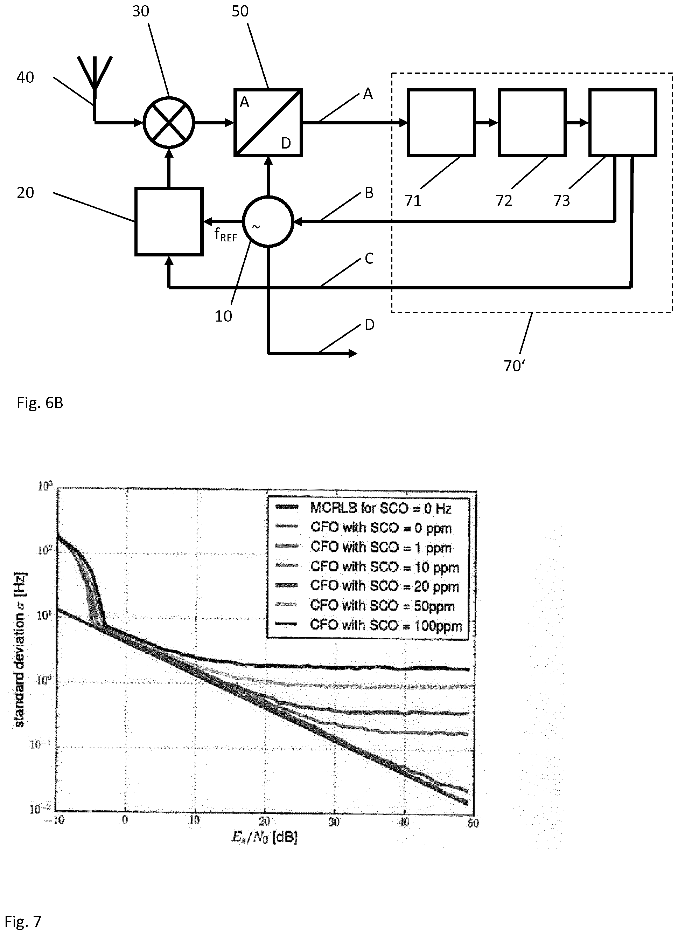

Die Prinzipschaltungen erfindungsgemäßer Regelvorrichtungen sind in Figur 6A und Figur 6B dargestellt.

Die in Figur 6A dargestellte Regelvorrichtung 70 empfängt das Ausgangssignal vom Ausgang A des Analog/Digital-Wandlers 50 des vorgehend beschriebenen Eingangsblocks des Empfängers und ist ausgebildet, ein erstes Korrektursignal an den Eingang B des Eingangsblocks des Empfängers auszugeben. Das erste Korrektursignal beeinflusst die lokale Referenzfrequenz des Oszillators 10 des Empfängers und damit unmittelbar die Trägerfrequenzverschiebung und den Abtastratenfehler des OFDM Empfängers. Eine Frequenzsynchronisation des Oszillators 10 mit der Frequenz des empfangenen Signal of Opportunity ist dann erreicht, wenn die Trägerfrequenzverschiebung und der Abtastratenfehler durch das erste Korrektursignal kompensiert werden.
Diese Regelvorrichtung kann vorteilhaft verwendet werden, wenn bei der Erzeugung eines OFDM modulierten Signals of Opportunity für die Generierung des Abtasttaktes und die Erzeugung der Trägerfrequenz die gleiche Referenzfrequenz verwendet wurde.

Die in Figur 6B dargestellte Regelvorrichtung 70' empfängt das Ausgangssignal vom Ausgang A des Analog/Digital-Wandlers 50 des vorgehend beschriebenen Eingangsblocks des Empfängers und ist ausgebildet, ein erstes Korrektursignal an den Eingang B des Eingangsblocks des Empfängers auszugeben und ein zweites Korrektursignal an den Eingang C des Eingangsblocks des Empfängers auszugeben. Wie bereits beschrieben, beeinflusst das erste Korrektursignal die lokale Referenzfrequenz des Oszillators 10 des Empfängers, während das zweite Korrektursignal die von der PLL 20 erzeugte Trägerfrequenz beeinflusst. Durch eine entsprechende Wahl des ersten und zweiten Korrektursignals wird es ermöglicht, die lokale Referenzfrequenz des Oszillators des Empfängers in Gleichlauf mit der Frequenz des Signals of Opportunity zu bringen und gleichzeitig die Trägerfrequenzverschiebung und den Abtastratenfehler des Empfängers getrennt zu beeinflussen.
Eine Frequenzsynchronisation des Oszillators 10 mit der Frequenz des empfangenen Signal of Opportunity ist dann erreicht, wenn die Trägerfrequenzverschiebung durch das erste und das zweite Korrektursignal kompensiert wird.
Diese Regelvorrichtung kann vorteilhaft verwendet werden, wenn bei der Erzeugung eines OFDM modulierten Signals of Opportunity für die Generierung des Abtasttaktes und die Erzeugung der Trägerfrequenz unterschiedliche Referenzfrequenzen verwendet wurden.

Vorzugsweise arbeiten die Regelvorrichtungen 70 und 70' iterativ und verarbeiten zumindest ein oder auch mehrere aufeinanderfolgende OFDM Symbole. Dazu enthalten die Regelvorrichtungen einen entsprechend dimensionierten Pufferspeicher 71 zur Zwischenspeicherung des digitalen Datenstroms des Analog/Digital-Wandlers 50. Die Regelvorrichtungen enthalten weiterhin Vorrichtungen 72 zur Bestimmung der Phasen und/oder der Phasenverhältnisse der Einzelträger eines oder mehrerer aufeinanderfolgender Symbole und Vorrichtungen 73 zur Schätzung der daraus resultierenden Trägerfrequenzverschiebung und/oder des Abtastratenfehlers. Aus der Trägerfrequenzverschiebung und/oder dem Abtastratenfehler werden das erste und gegebenenfalls das zweite Korrektursignal bestimmt.
Die durch Trägerfrequenzverschiebung und Abtastratenfehler verursachten Phasenverschiebungen können beispielsweise für die kontinuierlich übertragenen Pilotträger durch eine Korrelation des empfangenen Signals mit der bekannten Symbolsequenz der Pilotträger bestimmt werden. Eine weitere Möglichkeit ist eine Korrelation aktuell empfangener OFDM Symbole mit den einem Symbolschritt zuvor empfangenen OFDM Symbolen. Dabei kann eine Phasendifferenz beispielsweise als Differenz der Phasen zweier aufeinanderfolgender Symbole bestimmt werden.
Dieses bietet eine verbesserte Genauigkeit, da hierbei alle Einzelträger mit berücksichtigt werden. Die Bestimmung von Trägerfrequenzverschiebung und Abtastratenfehler kann in beiden Fällen mittels bekannter Schätzverfahren erfolgen.

Eine weitere Verbesserung der Genauigkeit der Bestimmung von Trägerfrequenzverschiebung und Abtastratenfehler kann erreicht werden, indem das empfangene Signal demoduliert und unter Nutzung der lokalen Referenzfrequenz nach dem gleichen Verfahren wie das Sendesignal wiederum moduliert wird. Die so gewonnene Kopie des Sendersignals wird mit dem empfangen Signal verglichen, um Abweichungen der Phasenlage der Einzelträger zu bestimmen.

Die Regelvorrichtung nach Figur 6A ist in einer Ausführungsform ausgebildet, das erste Korrektursignal aus der geschätzten Trägerfrequenzverschiebung zu bestimmen. In einer weiteren Ausführungsform ist die Regelvorrichtung nach Figur 6A ausgebildet, das erste Korrektursignal aus dem geschätzten Abtastratenfehler zu bestimmen. In einer weiteren Ausführungsform ist die Regelvorrichtung nach Figur 6A ausgebildet, das erste Korrektursignal aus der Kombination von geschätzter Trägerfrequenzverschiebung und geschätzten Abtastratenfehler zu bestimmen.

In analoger Weise ist die Regelvorrichtung nach Figur 6B ausgebildet, Schätzwerte für Trägerfrequenzverschiebung und/oder den Abtastratenfehler des Empfängers zu ermitteln, aus diesen das erste Korrektursignal und das zweite Korrektursignal so zu bestimmen, dass entweder die Trägerfrequenzverschiebung oder der Abtastratenfehler des Empfängers oder beide beeinflusst werden.

Figur 7 zeigt Simulationsergebnisse für den Einfluss der Abweichung des Abtastratenfehlers auf die Schätzung der Trägerfrequenzverschiebung. Dargestellt sind auf der X-Achse das Symbol / Rauschverhältnis E_{s/}N₀ in dB und auf der Y-Achse die Standardabweichung der Schätzung der Trägerfrequenzverschiebung (CFO) in Hz für Abtastratenfehler (SCO) von 0, 1, 10, 20, 50 und 100 ppm. Es ist zu erkennen, dass die Standardabweichung der Schätzung der Trägerfrequenzverschiebung (CFO) in Hz für die dargestellten Abtastratenfehler (SCO) von 0, 1, 10, 20, 50 und 100 ppm sukzessiv zunimmt.
Für Werte kleiner als 10 dB Eₛ/N₀ bewirkt eine Reduzierung des Abtastratenfehlers (SCO) keine signifikante Verbesserung der Ergebnisse der Schätzung der Trägerfrequenzverschiebung (CFO).
Es ist zu erkennen, dass für ein realistisches Empfangsverhältnis von 20 dB Eₛ/N₀ Abtastratenfehler (SCO) von weniger als 50 ppm kaum die Ergebnisse der Schätzung der Trägerfrequenzverschiebung (CFO) beeinträchtigen.

Die Regelvorrichtung 70' nach Figur 6B kann somit in einer Ausführungsform ausgebildet sein, die Korrektur von Trägerfrequenzverschiebung und der Abtastratenfehler in Abhängigkeit des Symbol / Rauschverhältnisses Eₛ/N₀ vorzunehmen. Weiterhin kann die Regelvorrichtung 70' ausgebildet sein, für Werte von Eₛ/N₀ unterhalb eines vorgegebenen Schwellenwertes nur die Trägerfrequenzverschiebung des Empfängers zu korrigieren.
Weiterhin kann die Regelvorrichtung 70' nach Figur 6B ausgebildet sein, iterativ zuerst den nur den Abtastratenfehler des Empfängers zu beeinflussen bis der Abtastratenfehler einen vorgegebenen Schwellenwert unterschreitet und anschließend die Trägerfrequenzverschiebung zu minimieren.

Beim Empfang des Signal of Opportunity insbesondere im Indoor Bereich ist mit eine starken Ausprägung des Mehrwegempfangs zu rechnen. Mehrwegempfang bedeutet, dass das vom Sender abgestrahlte Signal nicht nur über den direkten Empfangspfad (Line of Sight, LOS) empfangen wird, sondern das zusätzlich zeitlich verzögerte Signale empfangen werden. Ursachen dafür sind zum Beispiel Reflexion, Brechung, Streuung oder Beugung der gesendeten Signale. Auch ein Sender mit der gleichen Sendefrequenz, aber unterschiedlicher Position (Gleichkanalsender) kann als weitere Signalquelle auftreten. Der Mehrwegempfang führt dazu, dass der Empfänger über den Übertragungskanal ein Signal empfängt, das aus einer Überlagerung des Signals des direkten Empfangspfades und der Signale zeitlich verzögerter weiter Empfangspfade besteht. Das Verhalten des gesamten Übertragungskanals zwischen Sender und Empfänger wird durch die Kanalübertragungsfunktion beschrieben.
Änderungen der Kanalübertragungsfunktion führen zu einem Phasensprung im empfangenen Signal und beeinflussen damit die Schätzung der Trägerfrequenzverschiebung. Ist die Kanalübertragungsfunktion für verschiedene Sensorknoten unterschiedlich, führt dies zu unterschiedlichen Schätzergebnissen der einzelnen Sensorknoten. Bei OFDM Empfängern für Kommunikationsanwendungen wird deshalb oft nur eine differenzielle Änderung der Phase betrachtet, um die Trägerfrequenzverschiebung zu bestimmen, was jedoch zu einer verminderten Genauigkeit der Schätzung der Trägerfrequenzverschiebung führt.

Eine Lösung für dieses Problem ist, sich Kenntnis über den Kanal zu verschaffen und dann nur bestimmte Ausbreitungspfade daraus für die Schätzung der Trägerfrequenzverschiebung zu verwenden.

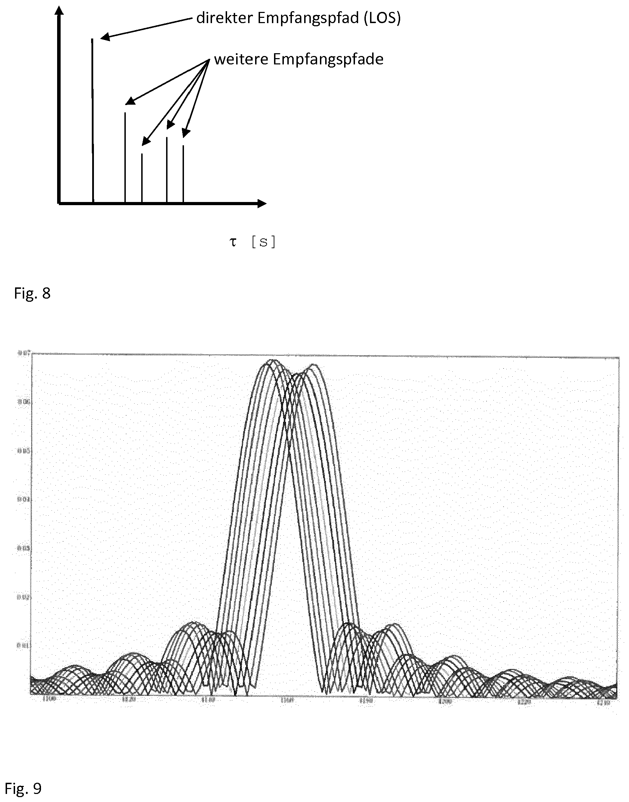

In OFDM Signale sind oft Mechanismen integriert, um die Kanaleigenschaften zu bestimmten. So gibt es in DVB-T und LTE Signalen die sogenannten verstreuten Pilotsignale und in DAB ein komplett bekanntes Referenzsymbol. Wird im Empfänger das bekannte Sendesignal dieser Pilotsignale mit den tatsächlich empfangenen Werten verglichen, so kann die Kanalübertragungsfunktion bestimmt werden. Wird diese mit Hilfe einer Inversen Fourier Transformation in den Zeitbereich überführt, so wird die Kanalimpulsantwort (channel impulse response, CIR) erhalten. Figur 8 zeigt eine Kanalimpulsantwort bei Mehrwegempfang. Dargestellt sind die Energie der über verschiedene Empfangspfade empfangenen Signalimpulse und deren zeitliche Verzögerung mit Bezug auf den Zeitpunkt der Aussendung. Der Empfangspfad mit der kürzesten zeitlichen Verzögerung entspricht dem direkten Empfangspfad (Line of Sight, LOS). Die weiteren Empfangspfade werden auch als Echos bezeichnet. Die Kanalimpulsantwort gibt Aufschluss über die zeitliche Aufspreizung der empfangenen Signale am Empfänger.

Bei einer direkten und ungestörten Sichtverbindung zwischen dem OFDM Sender und dem Empfänger des Sensorknotens enthält die Kanalimpulsantwort einen dominanten Impuls, der die Energie des über den direkten Empfangspfad empfangenen Signals repräsentiert. Die Kanalimpulsantwort enthält weiterhin mehrere kleine Impulse, die die Energie von z.B. von Häusern oder Bergen reflektierten Signale repräsentieren. Die Phasenlage eines Impulses in der Kanalimpulsantwort entspricht der mittleren Phasenlage der Pilottöne des empfangenen Signals. Durch Beobachtung der Phasenlage von jedem Impuls in der Kanalimpulsantwort über die Zeit, lässt sich aus jedem Impuls der Kanalimpulsantwort die entsprechende Trägerfrequenzverschiebung bestimmen. Jedoch existiert eine konstante Phasendrehung zwischen den Impulsen der einzelnen Echos und dem Impuls des direkten Empfangspfades der Kanalimpulsantwort. Diese Phasendrehung ist proportional zur Länge des Übertragungspfades der Echos.

Um die Genauigkeit der Schätzung der Trägerfrequenzverschiebung zu verbessern, erfolgt die vorgehend bereits beschriebene Bestimmung der Phasenveränderungen der Einzelträger des vom Empfänger empfangenen Signals in einer Ausführungsform ausschließlich für das über den direkten Empfangspfad empfangene Signal. In einer weiteren Ausführungsform erfolgt die Bestimmung der Phasenveränderungen der Einzelträger des vom Empfänger empfangenen Signals separat für jeden Empfangspfad. Dazu sind die Vorrichtungen 72 zur Bestimmung der Phasen und/oder der Phasenverhältnisse der Einzelträger eines oder mehrerer aufeinanderfolgender Symbole der Regelvorrichtungen 70 und 70' ausgebildet, die Kanalimpulsantwort des empfangenen Signals zu bilden und die Phasen der Impulse der Kanalimpulsantwort zu bestimmen.

Die Verwendung des über den direkten Empfangspfad empfangenen Signals ist dann vorteilhaft, wenn die Echos wesentlich kleiner sind als der dominante Impuls des direkten Empfangspfades. Der Energieverlust durch die Verwerfung der Information der Echos führt nur zu einer geringen Verschlechterung der der Schätzung der Trägerfrequenzverschiebung und führt zu einer Vereinfachung des Algorithmus.

Wenn der direkte Empfangspfad abgeschattet ist, das heißt, wenn der Pegel des direkten Empfangspfades nicht mehr dominant ist, z. B. wenn die empfangenen Echos ähnliche Pegelwerte wie der direkte Empfangspfad aufweisen, dann ist es vorteilhaft, die empfangenen Signale der leistungsstärksten Pfade zu verwenden. Nach einer anfänglichen Beobachtung der Phasen der einzelnen Impulse der Kanalimpulsantwort lässt sich der konstante Phasenversatz zwischen dem direkten Empfangspfad und den Echos bestimmen. Danach kann die Energie der einzelnen Pfade phasenkohärent kombiniert werden, um präzisere Ergebnisse für die Schätzung der Trägerfrequenzverschiebung zu erhalten. Wenn sich die Kanalübertragungsfunktion ändert, kommt es zu Änderungen der Anzahl der Impulse und deren zeitlicher Position in der Kanalimpulsantwort. In diesem Fall ist es vorteilhaft, neu hinzugekommene Impulse oder Impulse mit veränderter Position erst in die Schätzung der Trägerfrequenzverschiebung einzubeziehen, wenn diese für eine vorbestimmte Zeit stabil an einer Position in der Kanalimpulsantwort beobachtet werden. Die Genauigkeit der Phasenschätzung hängt von der Anzahl der für die Berechnung der Kanalimpulsantwort verwendeten Pilotträger oder Pilotsignale ab. Auch hier ist es vorteilhaft, eine Signalentscheidung der Datenträger bezüglich vorhandener Pilotsignale zu treffen und das bereits vorgehend beschriebene Verfahren der Re-Modulation des empfangen Signals anzuwenden, um die Energie für die Berechnung der Kanalimpulsantwort zu erhöhen.

In der Kanalimpulsantwort äußert sich eine Trägerfrequenzverschiebung in einer Phasenänderung der einzelnen Impulse. Ein Abtastratenfehler (SCO) äußert sich in einem "Wandern" der Impulse über die Zeit. Die Ursache hierfür ist, dass der Abtastratenfehler in Bezug zur nominalen Signaldauer zu einer zeitlichen Dehnung oder Stauchung des Signals führt. Wird nun für jedes Symbol die Kanalimpulsantwort berechnet, so ergibt sich eine Veränderung der Peak Position proportional zum Abtastratenfehler, wie in Figur 9 gezeigt, die die Abhängigkeit eines Peaks in der Kanalimpulsantwort vom Abtastratenfehler darstellt. Die x-Achse von Figur 9 stellt den Zeitpunkt der Kanalimpulsantwort dar, während die γ-Achse von Figur 9 die Amplitude der Kanalimpulsantwort darstellt. Die in Figur 9 dargestellten Kurven zeigen die Kanalimpulsantworten des gleichen Symbols für verschiedene Abtastratenfehler.

Wie bereits vorgehend beschrieben, ist es für die Bestimmung der Trägerfrequenzverschiebung nicht zwingend notwendig, den Abtastratenfehler vollständig zu korrigieren. Es muss jedoch darauf geachtet werden, dass es nicht zu Inter-Symbol-Interferenzen kommt, da in diesem Fall die Kanalimpulsantwort nicht mehr bestimmbar ist. Dies passiert, wenn für die Demodulation des OFDM Signals mit Hilfe der FFT Informationen aus unterschiedlichen OFDM-Symbolen verwendet werden. Auf einem Einzelträger werden die OFDM-Symbole zeitlich nacheinander übertragen, wobei die OFDM-Symbole durch Schutzintervalle (Guard-Interval) voneinander getrennt sind. Deshalb ist es vorteilhaft, den zeitlichen Beginn des Beobachtungsbereichs für die FFT in die Mitte des Schutzintervalls (Guard-Interval) zu legen. Dies ist möglich, wenn bis dahin alle Störungen durch Mehrwegempfang abgeklungen sind. Wird nun der Peak des direkten Empfangspfade über die Zeit beobachtet, wechselt dieser kontinuierlich die Position in eine Richtung auf der Zeitachse in Abhängigkeit vom Abtastratenfehler. Dieser Wechsel kann dadurch korrigiert werden, dass nach jedem Positionswechsel oder nach dem Überschreiten einer Beobachtungsschwelle ein oder mehrere zusätzliche Abtastwerte in den vom Analog/Digital-Wandler empfangen Datenstrom eingefügt werden oder der erste oder mehrere Abtastwerte des neuen Symbols verworfen werden. Dadurch wird die Position des Impulses des direkten Empfangspfades in der Kanalimpulsantwort des nächsten Symbols wieder auf den ursprünglichen Wert verschoben und das Beobachtungsintervall wird an einer konstanten Position gehalten. Inter-Symbol-Interferenzen werden dadurch vermieden und die Signalverfolgung bleibt stabil.

Beim Empfang des Signal of Opportunity kann es vorkommen, dass es kurzzeitig zu starken Änderungen der Kanaleigenschaften kommt. So kann ein bewegliches Hindernis, z.B. ein Passant, zu einer starken Dämpfung des direkten Empfangspfades führen, wenn das Hindernis durch Abschattung eine direkte Sichtverbindung zum Sender unterbricht. Deshalb ist es vorteilhaft, bei der Bestimmung der Phasenveränderungen der Einzelträger des vom Empfänger empfangenen Signals auch die Signalenergie oder die Signalqualität, wie beispielsweise den Signal-Störabstand (SIR) oder das Symbol / Rauschverhältnis der Impulse des Signals in der Kanalimpulsantwort zu beobachten. Wie aus Figur 7 ersichtlich, führt ein schlechteres Symbol / Rauschverhältnis zu schlechteren Schätzergebnissen der Trägerfrequenzverschiebung. Unterschreiten der Signal-Störabstand (SIR) oder das Symbol / Rauschverhältnis eines Impulses in der Kanalimpulsantwort einen vordefinierten Wert oder findet eine plötzliche Änderung statt, ist es vorteilhaft den darauf basierenden Schätzwert der Trägerfrequenzverschiebung in der iterativen Regelung zu verwerfen und statt dessen den zuvor ermittelten Schätzwert weiter zu verwenden, bis der Signal-Störabstand (SIR) oder das Symbol / Rauschverhältnis den vordefinierten Wert wieder überschreiten. Damit wird die Schätzung der Trägerfrequenzverschiebung robuster gegen durch beispielsweise durch Abschattungen verursachte kurzzeitige Veränderungen des Übertragungskanals.

In einer weiteren Ausführungsform erfolgt die Auswahl der zur Bestimmung der Phasenveränderungen der Einzelträger verwendeten Signale auf Basis des Signal-Störabstand (SIR) oder des Symbol / Rauschverhältnisses der Impulse des Signals in der Kanalimpulsantwort. Unterschreitet der Signal-Störabstand (SIR) oder das Symbol / Rauschverhältnis eines Impulses in der Kanalimpulsantwort einen vordefinierten Wert oder findet eine plötzliche Änderung statt, wird stattdessen ein anderer Impuls in der Kanalimpulsantwort verwendet. Dabei ist darauf zu achten, dass dessen Phase im Bezug zu den vorangegangenen Symbolen kontinuierlich ist bzw. keine stärkeren Sprünge aufweist. Dies würde auf eine Veränderung des Echopfades aufgrund des Abschattungsobjekts schließen.

Das Signal of Opportunity kann auch in einem so genannten Single-Frequency-Networks (SFN) ausgesendet werden. Das bedeutet, dass mehrere verteilte Senderstandorte das gleiche Signal zeitlich synchronisiert auf der gleichen Frequenz aussenden.

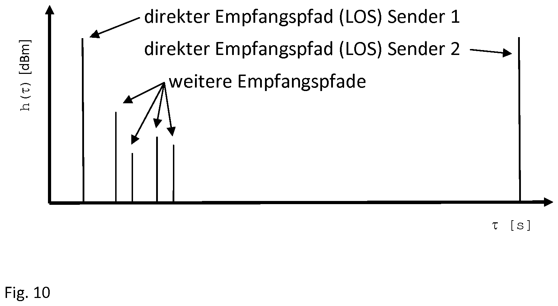

Figur 10 verdeutlicht die Auswirkung der Aussendungen zweier Sender in einem Single-Frequency-Network (SFN) in der Kanalimpulsantwort des Empfängers eines Sensorknotens. Das Signal des geographisch näher am Sensornetzwerk liegende Senders 1 hat einen kürzeren direkten Empfangspfad und wird daher zeitlich früher vom Empfänger empfangen. Das Signal des geographisch weiter vom Sensornetzwerk entfernten Senders 2 hat einen längeren direkten Empfangspfad und wirkt wie ein energiereicher Mehrwegempfangspfad des Senders 1 mit langem Ausbreitungspfad. Aufgrund der geographisch unterschiedlichen Positionen des Senders 1 und des Senders 2 werden die Signale der Sender von den Empfängern im Sensornetzwerk aus verschiedenen Einfallsrichtungen empfangen. Ein bewegliches Hindernis würde dann nur einen der beiden energiereichen Pfade abschatten. Somit kann die vorgehend beschriebene Auswahl der zur Bestimmung der Phasenveränderungen der Einzelträger verwendeten Signale auf Basis des Signal-Störabstand (SIR) oder des Symbol / Rauschverhältnis der Impulse des Signals in der Kanalimpulsantwort auch beim Empfang von mehreren Sendern eines Single-Frequency-Network (SFN) erfolgen. In einer Weiterbildung werden getrennte Oszillatoren mit unabhängigen Regelschleifen für jeden Sender verwendet.

Für viele Sensornetzwerke ist keine absolute Syntonisation der lokalen Referenzoszillatoren der einzelnen Sensorknoten bezogen auf eine hochgenaue Referenzfrequenz notwendig, sondern nur eine möglichst gute Syntonisation zwischen den lokalen Referenzoszillatoren der einzelnen Sensorknoten. In einem geographisch begrenzten Sensornetzwerk mit mehreren Sensorknoten wirkt die Abschattung des direkten Empfangspfades eines Senders auf alle Sensorknoten des Sensornetzwerkes gleichermaßen. In einer Ausführungsform ist ein Sensorknoten ausgebildet, anhand einer Unterschreitung von Signal-Störabstand (SIR) oder Symbol / Rauschverhältnis eine Abschattung eines ersten Referenzsenders zu erkennen und nachfolgend die Frequenzsynchronisation des lokalen Referenzoszillators mit einem zweiten Referenzsender fortzuführen. Dabei kann der zweite Referenzsender auch ein Sender einer anderen Frequenz oder eines anderen Übertragungsstandards sein. Der Sensorknoten kann weiterhin ausgebildet sein, die Information über den aktuell verwendeten Referenzsender an mit ihm kommunikativ verbundene weitere Sensorknoten zu übertragen oder diese Information von einem anderen Sensorknoten zu empfangen und daraufhin die Frequenzsynchronisation des lokalen Referenzoszillators mit dem Referenzsender des anderen Sensorknotens fortzuführen. Wie bereits beschrieben, kann in diesem Fall bis zum Bestimmung von neuen Schätzwerten der Trägerfrequenzverschiebung in der iterativen Regelung der zuletzt ermittelte Schätzwert der Trägerfrequenzverschiebung weiter verwendet werden.

Neben der Frequenzsynchronisation der Sensorknoten ist auch eine Zeitsynchronisation, also der Abgleich der unterschiedlichen lokalen Uhrzeiten der einzelnen Sensorknoten auf eine externe Referenzzeit wie zum Beispiel die koordinierten Weltzeit (Coordinated Universal Time, UTC) wünschenswert, um zum Beispiel bei Laufzeitmessungen eine Laufzeitdifferenz zwischen den einzelnen Sensorknoten bestimmen zu können. Viele der vorgehend benannten, als Signal of Opportunity geeigneten Funksignale beinhalten Zeitstempel mit unterschiedlicher Genauigkeit, mit denen die Empfänger zeitlich synchronisiert werden oder die Uhrzeit bereitgestellt wird. Mit diesen Zeitstempeln kann eine Zeitsynchronisation der Sensorknoten erreicht werden.

Die vorgehend beschriebenen Verfahren sind ebenfalls für WLAN-Signale (IEEE-802.11) als Signal of Opportunity anwendbar. WLAN-Sender sind kostengünstig, kompakt und flexibel einsetzbar. Da WLAN-Signale im Gegensatz zu den Aussendungen von DVB-T, DAB oder LTE nicht kontinuierlich abgestrahlt werden, sind die vorgehend beschriebenen Verfahren dahingehend anzupassen, dass fehlende Schätzwerte der Trägerfrequenzverschiebung die Frequenzsynchronisation nicht negativ beeinflussen. Wie bereits beschrieben, kann dazu in vorteilhafter Weise in der iterativen Regelung der zuletzt ermittelte Schätzwert der Trägerfrequenzverschiebung so lange weiter verwendet werden, bis ein neuer Schätzwert der Trägerfrequenzverschiebung bestimmt wurde.
Eine weitere Verbesserung kann durch eine Anpassung der Router Hardware erreicht werden. Vorteilhaft ist ein durchgehend aktiver, möglichst stabiler Oszillator als Referenzfrequenz für den ausgewählten WLAN-Sender, um Frequenzabweichungen zu minimieren, die beispielsweise dem Einschalten des Oszillators für einen bestimmten Zeitraum auftreten. Weiterhin ist es vorteilhaft, die Referenzfrequenz bei der Erzeugung der OFDM modulierten Signale sowohl für die Generierung des Abtasttaktes und als auch für die Erzeugung der Trägerfrequenz zu verwenden. Der Vorteil ist eine starre Kopplung Trägerfrequenzverschiebung und Abtastratenfehler.

Sollte, wie beispielsweise im Indoor-Bereich, der Empfang des gewählten Signal of Opportunity nicht möglich oder eingeschränkt sein können entsprechende Sender kleiner Leistung installiert werden. Alternativ können passive oder aktive Repeater verwendet werden.

## Patentansprüche

1. Verfahren zur Frequenzkorrektur eines Oszillators (10) eines Sensorknotens eines Sensornetzwerkes mit den Verfahrensschritten:
- Empfangen eines Sendesignals eines ersten Senders mit einer Modulation nach dem Orthogonalen Frequenzmultiplexverfahren, OFDM;
- Bestimmen der Frequenzabweichung des Oszillators (10) anhand des empfangenen Sendesignals;
- Bestimmen eines Korrektursignals zur Korrektur der Frequenzabweichung des Oszillators (10);
- Korrektur der Frequenz des Oszillators (10) mit dem Korrektursignal;
wobei der Sensorknoten mit weiteren Sensorknoten kommunikativ verbunden ist;
**dadurch gekennzeichnet**
**dass** der Sensorknoten von einem weiteren Sensorknoten die Information über den von dem weiteren Sensorknoten aktuell zur Frequenzkorrektur verwendeten zweiten Sender empfängt und daraufhin die Frequenzkorrektur mit diesem Sender fortführt, wenn anhand einer Unterschreitung von Signal-Störabstand oder Symbol/Rauschverhältnis eine Abschattung des ersten Senders erkannt wird.

2. Verfahren nach Anspruch 1, wobei zur Bestimmung der Frequenzabweichung des Oszillators (10) eine Trägerfrequenzabweichung des empfangenen Sendesignals bestimmt wird.

3. Verfahren nach einem der vorgehenden Ansprüche, wobei zur Bestimmung der Frequenzabweichung des Oszillators (10) ein Abtastratenfehler des empfangenen Sendesignals bestimmt wird.

4. Verfahren nach Anspruch 3, wobei der Abtastratenfehler unabhängig von der Korrektur der Frequenzabweichung des Oszillators (10) korrigiert wird.

5. Verfahren nach einem der vorgehenden Ansprüche, wobei die Bestimmung der Frequenzabweichung anhand der Phasenbeziehungen empfangener Einzelträger des Sendesignals erfolgt.

6. Verfahren nach Anspruch 3, wobei die Bestimmung des Abtastratenfehlers anhand der Phasenbeziehungen empfangener Einzelträger des Sendesignals erfolgt.

7. Verfahren nach einem der vorgehenden Ansprüche, wobei die Bestimmung der Frequenzabweichung für den Zeitraum der Übertragung eines Sendesymbols vorgenommen wird.

8. Verfahren nach einem der vorgehenden Ansprüche, wobei die Bestimmung der Frequenzabweichung für den Zeitraum der Übertragung zweier aufeinander folgender Sendesymbole vorgenommen wird.

9. Verfahren nach einem der vorgehenden Ansprüche, wobei
- nach dem Empfangen des Sendesignals aus dem empfangenen Sendesignal die Kanalimpulsantwort des Übertragungskanals bestimmt wird;
- aus der Kanalimpulsantwort die Signale unterschiedlicher Übertragungspfade des empfangenen Sendesignals bestimmt werden; und
- die Frequenzabweichung des Oszillators anhand des Signals eines Übertragungspfades bestimmt wird.

10. Verfahren nach Anspruch 9, wobei die Frequenzabweichung des Oszillators anhand der Signale mehrerer Übertragungspfade bestimmt wird.

11. Verfahren einem der Ansprüche 9 oder 10, wobei das Signal zur Bestimmung der Frequenzabweichung des Oszillators anhand seiner Signalenergie, seiner Signalqualität oder seiner zeitlichen Beziehung zu anderen Signalen der Kanalimpulsantwort ausgewählt wird.

12. Verfahren nach einem der vorgehenden Ansprüche, wobei die Sendesignale mehrerer Sender empfangen werden.

13. Verfahren nach einem der vorgehenden Ansprüche, wobei das empfangene Sendesignal Zeitinformationen enthält und der Oszillator (10) anhand der Zeitinformation zeitsynchronisiert wird.

## Claims

1. A method for the frequency correction of an oscillator (10) of a sensor node of a sensor network with the method steps:
- receiving a transmission signal of a first transmitter with a modulation according to orthogonal frequency-division multiplexing (OFDM);
- determining the frequency deviation of the oscillator (10) based on the received transmission signal;
- determining a correction signal for the correction of the frequency deviation of the oscillator (10);
- correcting the frequency of the oscillator (10) with the correction signal;
wherein the sensor node is communicatively connected to further sensor nodes;
**characterised in that**
the sensor node receives information about a second transmitter currently used for frequency correction from a further sensor node and subsequently continues the frequency correction with this transmitter when shadowing of a first reference transmitter is recognised on the basis of a signal-to-interference ratio or symbol/noise ratio falling below a predefined value.

2. A method according to claim 1, wherein a carrier frequency deviation of the received transmission signal is determined for determining the frequency deviation of the oscillator (10).

3. A method according to one of the preceding claims, wherein a sampling clock offset of the received transmission signal is determined for determining the frequency deviation of the oscillator (10).

4. A method according to claim 3, wherein the sampling clock offset is corrected independently of the correction of the frequency deviation of the oscillator (10).

5. A method according to one of the preceding claims, wherein the determining of the frequency deviation is effected based on the phase relations of received individual carriers of the transmission signal.

6. A method according to claim 3, wherein the determining of the sampling clock offset is effected based on the phase relations of received individual carriers of the transmission signal.

7. A method according to one of the preceding claims, wherein the determining of the frequency deviation is carried out for the time period of the transmission of a transmission symbol.

8. A method according to one of the preceding claims, wherein the determining of the frequency deviation is carried out for the time period of the transmission of two consecutive transmission symbols.

9. A method according to one of the preceding claims, wherein
after receiving the transmission signal, the channel impulse response of the transmission channel is determined from the received transmission signal;
the signals of different transmission paths of the received transmission signal are determined from the channel impulse response; and
the frequency deviation of the oscillator is determined based on the signal of a transmission path.

10. A method according to claim 9, wherein the frequency deviation of the oscillator is determined based on the signal of a plurality of transmission paths.

11. A method according to one of the claims 9 or 10, wherein a signal for determining the frequency deviation of the oscillator is selected based on its signal energy, its signal quality or its temporal relation to other signals of the channel impulse response.

12. A method according to one of the preceding claims, wherein the transmission signals of a plurality of transmitters are received.

13. A method according to one of the preceding claims, wherein the received transmission signal comprises time information and the oscillator (10) is time-synchronised based on the time information.

## Revendications

1. Procédé de correction de fréquence d'un oscillateur (10) d'un noeud de capteurs d'un réseau de capteurs, avec les étapes de procédé :
- la réception d'un signal d'émission d'un premier émetteur avec une modulation selon le procédé de multiplexage par répartition orthogonale de la fréquence, OFDM ;
- la détermination d'une déviation de fréquence de l'oscillateur (10) à l'aide du signal d'émission reçu ;
- la détermination d'un signal de correction pour la correction de la déviation de fréquence de l'oscillateur (10) ;
- la correction de la fréquence de l'oscillateur (10) avec le signal de correction ;
où le nœud de capteurs est relié de manière communicative avec d'autres nœuds de capteurs ;
**caractérisé en ce**
**que** le nœud de capteurs reçoit à partir d'un autre nœud de capteurs l'information concernant le deuxième émetteur employé pour la correction de la fréquence par l'autre nœud de capteurs actuel et ensuite, exécute la correction de fréquence avec cet émetteur lorsqu'une masquage du premier émetteur est détectée à l'aide d'un sous-dépassement du rapport signal - bruit de fond ou du rapport symbole/bruit.

2. Procédé selon la revendication 1, dans lequel, une déviation de fréquence porteuse du signal d'émission reçu est déterminée pour la détermination de la déviation de fréquence de l'oscillateur (10).

3. Procédé selon l'une des revendications précédentes, dans lequel un défaut de fréquence d'échantillonnage du signal d'émission est déterminé pour la détermination de la déviation de fréquence de l'oscillateur (10).

4. Procédé selon la revendication 3, dans lequel le défaut de fréquence d'échantillonnage est corrigé de manière indépendante par rapport à la correction de la déviation de fréquence de l'oscillateur (10).

5. Procédé selon l'une des revendications précédentes, dans lequel la détermination de la déviation de fréquence s'effectue à l'aide de relations de phases de porteuses individuelles du signal d'émission.

6. Procédé selon la revendication 3, dans lequel la détermination du défaut de fréquence d'échantillonnage s'effectue à l'aide des relations de phases de porteuses individuelles reçues du signal d'émission.

7. Procédé selon l'une des revendications précédentes, dans lequel la détermination de la déviation de fréquence est effectuée pour l'intervalle de temps de la transmission d'un symbole d'émission.

8. Procédé selon l'une des revendications précédentes, dans lequel la détermination de la déviation de fréquence est effectuée pour l'intervalle de temps de la transmission de deux symboles d'émission se succédant l'un à l'autre.

9. Procédé selon l'une des revendications précédentes, dans lequel,
après la réception du signal d'émission, on détermine la réponse d'impulsion de canal du canal de transmission à partir du signal d'émission reçu ;
les signaux de différents chemins de transmission du signal d'émission reçu sont déterminés à partir de la réponse d'impulsion de canal ; et
la déviation de fréquence de l'oscillateur est déterminée à l'aide du signal d'un chemin de transmission.

10. Procédé selon la revendication 9, dans lequel la déviation de fréquence de l'oscillateur est déterminée à l'aide des signaux de plusieurs chemins de transmission.

11. Procédé selon l'une des revendications 9 ou 10, dans lequel le signal pour la détermination de la déviation de fréquence de l'oscillateur est choisi à l'aide de son énergie de signal, de sa qualité de signal ou de sa relation temporelle par rapport à d'autres signaux de la réponse d'impulsion de canal.

12. Procédé selon l'une des revendications précédentes, dans lequel les signaux d'émission de plusieurs émetteurs sont reçus.

13. Procédé selon l'une des revendications précédentes, dans lequel le signal d'émission reçu contient des informations temporelles et l'oscillateur (10) est synchronisé en temps à l'aide de l'information temporelle.
